Europäisches Patentamt

European Patent Office

Office européen des brevets

(11) Veröffentlichungsnummer: **0 192 206**
A2

# (12) EUROPÄISCHE PATENTANMELDUNG

(21) Anmeldenummer: **86101920.6**

(22) Anmeldetag: **14.02.86**

(51) Int. Cl.⁴: **B 65 G 1/08**
**B 65 G 59/06**

(30) Priorität: **19.02.85 DE 3505700**

(43) Veröffentlichungstag der Anmeldung:
**27.08.86 Patentblatt 86/35**

(84) Benannte Vertragsstaaten:
**AT CH DE FR GB LI**

(71) Anmelder: **MICROHANDLING Handhabungsgeräte
GmbH
Gollierstrasse 70/III
D-8000 München 2(DE)**

(72) Erfinder: **Dahinten, Heinz
Mathunistrasse 13
D-8000 München 21(DE)**

(74) Vertreter: **Seibert, Rudolf, Dipl.-Ing. et al,
Tattenbachstrasse 9
D-8000 München 22(DE)**

(54) **Vorrichtung zum Magazinieren von länglichen Verpackungseinheiten für elektrische, insbesondere elektronische, integrierte Schaltkreise (IC's) aufweisende Bauteile.**

(57) Die Erfindung bezieht sich auf eine Vorrichtung zum Magazinieren von länglichen Verpackungseinheiten für elektrische, insbesondere elektronische, integrierte Schaltkreise (IC's) aufweisende Bauteile, wie sie im besonderen zum kontinuierlichen Zuführen bzw. Ablegen der Bauteile an einen Handler (Bauteileprüf- und/oder sortierautomat) benötigt wird.

Dabei ist die Magaziniervorrichtung erfindungsgemäß durch eine am Handler aufsetz- oder anstechbar, eine Mehrzahl von im lichten Durchmesser den Außenabmessungen der Verpackungseinheiten angepaßten Einstecköffnungen aufweisende Kassette mit Durchlaßöffnungen in der Bodenplatte zum Druchtritt der Bauteile ausgebildet. Die Kassette kann zur Aufnahme von Verpackungseinheiten gleicher Querschnittsform aber auch ungleicher Querschnittsform ausgebildet sein.

FIG.1

Vorrichtung zum Magazinieren von länglichen
Verpackungseinheiten für elektrische, insbesondere
elektronische, integrierte Schaltkreise (IC's)
aufweisende Bauteile

Die Erfindung bezieht sich auf eine Vorrichtung zur Aufnahme von länglichen Verpackungseinheiten für elektrische, insbesonder elektronische integrierte Schaltkreise aufweisende Bauteile zum fortlaufenden Zuführen bzw. Ablegen der Bauteile an bzw. von einem Handler, also einem Bauteileprüf- und/oder Sortierautomat. Es ist üblich, Bauteile mit integrierten elektronischen Schaltkreisen, sogenannte IC's in sogenannten IC-Stangen aufzubewahren und zu transportieren. Dabei werden diese IC-Stangen meist in Behältern transportiert. Zum Prüfen, Sortieren oder zum Verarbeiten der einzelnen IC's werden die IC-Stangen meist einzeln aus den Behältern entnommen und der Inhalt einem Magazin der entsprechenden Verarbeitungsmaschine zugeführt, bzw. die Bauteile werden nach der Bearbeitung in die IC-Stangen gefüllt. Die so gefüllten IC-Stangen werden wiederum einzeln in einen Transportbehälter abgelegt.

Eine Automatisierung in der Handhabung der einzelnen IC-Stangen war bislang nicht möglich, nicht zuletzt wegen der Vielfalt der IC-Stangen in ihren Abmessungen. Dabei mußten in vielen Fällen sogar die Magazine bzw. Handhabungsvorrichtungen der einzelnen Verarbeitungsmaschinen in unterschiedlichen Bauformen bzw. Baugrößen der IC-Stangen und den Bauteilen selbst angepaßt bzw. neu justiert werden. Da darüber hinaus im allgemeinen relativ wenige Bauteile in einer Verpackungseinheit untergebracht werden können, ist an den Maschinen wegen deren hoher Verarbeitungsgeschwindigkeit ein schneller Wechsel der IC-Stangen notwendig, der aber in vielen Fällen mit der Verarbeitungsgeschwindigkeit der Maschinen selbst nicht Schritt halten kann, so daß die Maschinen vielfach nicht optimal ausgenutz werden.

Der Erfindung liegt die Aufgabe zugrunde, herkömmliche Verpackungseinheiten zu größeren, einfach handzuhabenden Einheiten verarbeitungsgerecht zusammenzufassen, und zwar unter Verwendung der herkömmlichen Verpackungseinheiten. Dabei soll die aufgabengemäß zu schaffende Einheit zur Zusammenfassung der IC-Stangen gemäß einer Erweiterung der Aufgabenstellung so geschaffen sein, daß auch Verpackungseinheiten verschiedener Größe und Querschnittsform eingesetzt werden können. Die erfindungsgemäß zu schaffende Einheit soll dabei so gestaltet sein, daß ein selbsttätiges Entnehmen bzw. Zuführen der einzelnen Bauteile aus bzw. in die Stangen möglich ist.

Diese Aufgabe wird mit einer Vorrichtung mit den Merkmalen nach dem Patentanspruch 1 gelöst. Vorteilhafte Ausgestaltungen und Weiterbildungen ergeben sich aus den Unteransprüchen.

Gemäß der Erfindung wird also eine an einen Handler aufsetz- bzw. an den Handler ansteckbare Kassette mit Einsicköffnung vorgesehen, in die die einzelnen Verpackungseinheiten unmittelbar eingesteckt werden können. Die Kassette weist in ihrer Bodenplatte Durchlaßöffnungen zum definierten Durchtritt der einzelnen Bau-teile auf. Dabei kann die Kassette gemäß vorteilhafter Ausgestaltung sowohl mit einer Vielzahl gleicher Querschnittsformen zur Aufnahme einer Mehrzahl von Verpackungseinheiten gleichen Querschnittes aber auch durch unterschiedliche Gestaltung der Einsicköffnungen zur Aufnahme von Verpackungseinheiten ungleicher Querschnittsform ausgebildet sein.

Um eine leichte Anpaßbarkeit einer Kassette an unterschiedliche Querschnittsformen zu ermöglichen kann gemäß einer anderen Weiterbildung des Erfindungsgedankens die Kassette auch aus einzelnen Baueinheiten zusammensetzbar ausgebildet sein, wobei die Baueinheiten äußerlich gleichartig jedoch im Sonderfall in den Ausnehmungen zur Aufnahme der IC-Stangen unterschiedlich aufgebaut sein können.

Die Einsicköffnungen sind dabei vorzugsweise so ausgebildet, daß die IC-Stangen bis zur Grundplatte eingeschoben werden können. In der Grundplatte sind Öffnungen, die die Form und die Abmessungen der lichten Öffnungen der IC-Stangen haben, so daß die einzelnen Bauteile ohne Behinderung durch vorstehende Kanten oder Ecken unmittelbar hindurch

3     01 9 2 2 0 6

gleiten können. Dabei wird in den meisten Ausführungsformen die Schwerkraft zur Entnahme bzw. zum Einfüllen ausgenutzt.

Zum aufeinanderfolgenden Abarbeiten der Bauteile aus den in der Kassette nach der Erfindung zusammengefaßten IC-Stangen sind gemäß einer anderen Weiterbildung an der Kassette bzw. deren Grundplatte Führungs- und/oder Transportglieder für eine Längs- und Querbewegung des Magazins an der Verarbeitungsmaschine für die Bauteile vorgesehen. Dabei ist es vorteilhaft, zur Längsbewegung der Kassette an der Kassette selbst eine Zahnstange vorzusehen, die mit am Handler vorgesehenen Transporteinrichtungen wie Zahnrad, Zahnriemen, Klinkenantrieb usw. zusammenwirkt.

Die einzelnen IC-Stangen werden kraftschlüssig in den einzelnen Einstecköffnungen gehalten, die dementsprechend der äußeren Form der IC-Stangen angepaßt sind. Um Toleranzen in den Maßen der IC-Stangen aber auch in den Einstecköffnungen sicher auszugleichen und einen guten Sitz der IC-Stangen in den Einstecköffnungen zu garantieren, werden vorzugsweise in den Einstecköffnungen elastische Federglieder vorgesehen, die den lichten Raum der Einstecköffnung entsprechend elastisch verkleinern und in die Wandung der Einstecköffnung zurückgedrückt werden können. Als besonders vorteilhaft hat sich hierbei das Anbringen eines Gummirundkörpers in einer quer zu den Einstecköffnungen über die ganze Länge des Magazins verlaufenden Nut erwiesen. Um beim Einstecken der einzelnen IC-Stangen mit der Vorderkante den Gummirundkörper nicht zu beschädigen oder aus der Nut zu drücken, empfielt es sich dabei, die aus der Wandung heraustretende Oberfläche des Gummirundkörpers mit einer nachgiebigen Gleitfolie, vorzugsweise einer den Anpreßdruck vergrößernden kleinen Blattfeder in jeder einzelnen Einstecköffnung abzudecken. Um höhere Reibungsdrücke zu erreichen, kann es sich empfehlen über die Länge oder auch an gegenüberliegenden Stirnseiten der Einstecköffnung mehrere derartige federnde Elemente anzubringen. Dies wird dann zweckmäßig sein, wenn die Kassette nach der Erfindung als Ablagemagazin an einem Handler eingesetzt werden soll, also dann, wenn die einzelnen IC-Stangen aus der Kassette nach unten hängend herausragen und die einzelnen Bauteile in die einzelnen IC-Stangen gleiten.

Um das Einsetzen bzw. Wegnehmen der Kassette zu vereinfachen ist es vorteilhaft, die Durchlaßöffnungen in der Bodenplatte verschließbar bzw. zumindest teilverschließbar zu machen, damit beim Transport der Kassette keine Bauteile ungewollt herausfallen können. Das Verschließen der einzelnen Öffnungen kann dabei mit einem Blendenschieber, einer Verriegelungsstange oder einem anderen den lichten Querschnitt der Öffnung verkleinendern Klapp- oder Schiebeteil erfolgen.

Für das automatische Abarbeiten der über eine Kassette nach der Erfindung zusammengefaßten Bauelemente ist es weiter vorteilhaft, wenn Markierungen, die optisch oder mechanisch abgetastet werden können an der Kassette vorhanden sind, um diese hinsichtlich der einzelnen Durchlaßöffnunge genau positionieren zu können. Dies kann beispielsweise mit einer Loch oder Schlitzblende für die optische Abtastung erfolgen. Weiter kann für die Verarbeitung an der Kassette selbst ein automatisch lesbarer Speicher, vorzugsweise in Form eines Magnetbandstückes vorgesehen werden, das beispielsweise Informationen über die in der Kassette befindlichen Bauteile hinsichtlich Qualität, Größe, Stückzahl usw. enthält.

Im folgenden wird eine bevorzugte Ausführungsform einer Kassette in Verbindung mit der anliegenden Zeichnung erläutert. In der Zeichnung zeigen:

Fig. 1        eine Seitenansicht der bevorzugten Ausführungsform, dargestellt als Entnahmemagazin,

Fig. 2        eine Draufsicht auf die Anordnung nach Fig. 1 und

Fig. 3        einen Schnitt quer zur Anordnung nach Fig. 1.

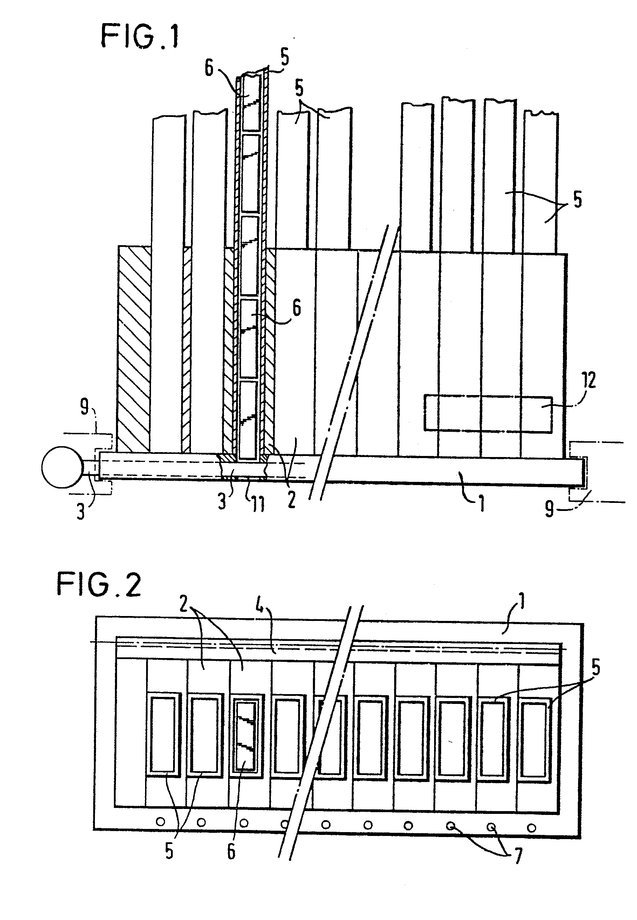

Bei der dargestellten Ausführungsform nach Fig. 1 ist das Magazin aus einer Grundplatte 1 mit darauf befestigten einzelnen Baueinheiten zur Aufnahme von IC-Stangen 5 aufgebaut. In den einzelnen IC-Stangen 5 sind flache, quaderförmige elektrische Bauteile 6 (IC's) enthalten.

Es sei an dieser Stelle angemerkt daß, an die Gesamtheit von Bodenplatte 1 und Baueinheiten 2 auch einstückig ausgebildet sein kann.

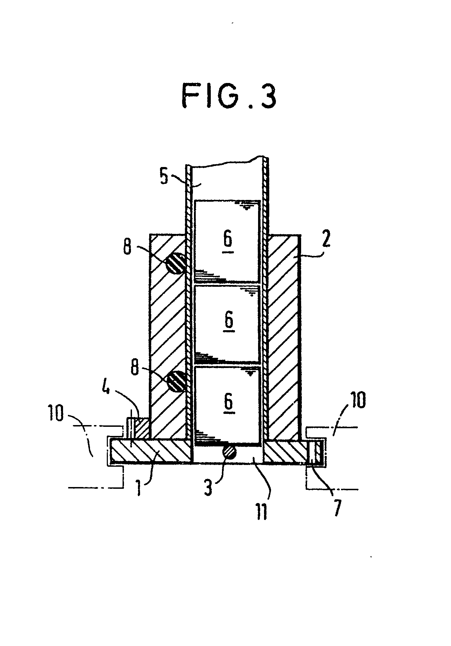

Die Einsteköffnung in den einzelnen Baueinheiten 2 sind so ausgebildet, daß die IC-Stangen exakt über den in der Bodenplatte vorgesehenen Durchlaßöffnungen 11 (Fig. 3) fixiert sind. Dabei sind die Ausnehmungen in den Baueinheiten 2 den Abmessungen, ggfs. auch den unterschiedlichen Abmessungen der IC-Stangen in Form und Größe angepaßt. Die Durchlaßöffnung 11 ist in seinen Abmessungen der Größer der einzelnen Bauteile, also im allgemeinen den zugehörigen Öffnungen der IC-Stangen nachgebildet, um einen störungsfreien Durchsatz der Bauteile zu gewährleisten. Aus den Fign. 1 und 3 ist zu ersehen, daß der Durchtritt der Bauteile mit Hilfe eines Riegels 3 unterbunden werden kann. Der Riegel 3 verhindert im eingeschobenen Zustand einen Durchtritt der Bauteile. Wird der Riegel 3 entfernt, werden die Durchlaßöffnungen frei und die Bauteile 6 können die IC-Stangen bzw. die Kassette verlassen oder bei umgekehrter Anordnung in die Kassette bzw. die IC-Stangen eingefüllt werden.

Mit 9 ist in Fig. 1 schematisch die Anordnung einer Querführung der Kassette dargestellt, während mit 10 in Fig. 3 schematisch die Anordnung einer Längsführung gezeigt ist. Diese Führungen bzw. eine der Führungen je nach dem Einsatz der Kassette und der Ausbildung des Handlers sind an diesem bzw. an einer anderen Arbeitsmaschine vorgesehen.

Mit 4 ist in den Fig. 1 und 3 eine Zahnstange angedeutet, die mit einem entsprechenden Antrieb am Handler bzw. der Verarbeitungsmaschine eine definierte Verschiebung des Magazins zur Positionierung der Durchlaßöffnungen 11 zum Zwecke der Entnahme bzw. zum Befüllen ermöglicht. Der entsprechende Antrieb kann in Form eines Zahnrades, eines Zahnriemens oder aber auch eines Klinkenantriebes mit einem oder mehreren Klinken durchgeführt werden. Um eine genaue Positionierung der Durchlaßöffnungen steuern zu können, sind Lochblenden vorgesehen, die mechanisch oder optisch abgetastet werden können und die den Antrieb über die Zahnstange entsprechend steuern.

Mit 12 ist ein Lese- und/oder Schreibspeicher in Fig. 1 angedeutet. Die auf diesem Speicher vorhandenen oder zu übernehmenden Informationen

6

können beim Transport der Kassette am Handler in an sich bekannter Weise gelesen bzw. geschrieben werden.

Die Erfindung wurde in Verbindung mit einem besonders einfachen Ausführungsbeispiel erläutert. Für den auf dem Fachgebiet tätigen Fachmann ist ersichtlich, daß im Rahmen der Erfindung eine Reihe von Abwandlungen sowie Ergänzungen möglich sind. Insbesondere die Steuerungsmöglichkeit für die Bewegung der Kassette in Verbindung mit einem Handler und die Steuerung des Transportes kann auf verschiedene Weise erfolgen.

Vorrichtung zum Magazinieren von länglichen
Verpackungseinheiten für elektrische, insbesondere
elektronische, integrierte Schaltkreise (IC's)
aufweisende Bauteile

Patentansprüche

1. Vorrichtung zum Magazinieren von länglichen Verpackungseinheiten für elektrische, insbesondere elektronische, integrierte Schaltkreise aufweisende Bauteile zum kontinuierlichen Zuführen bzw. Ablegen der Bauteile an einen Händler (Bauteileprüf- und/oder -sortierautomat), gekennzeichnet durch eine am Handler aufsetz- oder ansteckbare, eine Mehrzahl von im lichten Durchmesser den Außenabmessungen der Verpackungseinheiten (5) angepaßten Einstecköffnungen aufweisende Kassette mit Durchlaßöffnungen (11) in der Bodenplatte (1) zum Durchtritt der Bauteile (2).

2. Vorrichtung nach Anspruch 1, dadurch gekennzeichnet, daß die Kassette (1,2) zur Aufnahme einer Mehrzahl von Verpackungseinheiten (5) gleicher Querschnittsform ausgebildet ist.

3. Vorrichtung nach Anspruch 1, dadurch gekennzeichnet, daß die Kassette (1,2) zur Aufnahme von Verpackungseinheiten (5) ungleicher Querschnittsform ausgebildet ist.

4. Vorrichtung nach Anspruch 1 bis 3, dadurch gekennzeichnet, daß die Kassette aus einzelnen jeweils gleichartigen Bau-einheiten (2) aufgebaut ist.

5. Vorrichtung nach Anspruch 4, dadurch gekennzeichnet. daß jede Baueinheit (2) zur Aufnahme einer Verpackungseinheit (5) ausgelegt ist.

6. Vorrichtung nach Anspruch 4 oder 5, dadurch gekennzeichnet, daß die einzelnen Baueinheiten (2) mittels einer Grundplatte (1) zusammengehalten sind.

7. Vorrichtung nach einer der Ansprüche 1 bis 6, dadurch gekennzeichnet, daß die Kassette bzw. deren Grundplatte (1) Führungs- und/oder Transportglieder für Längs- und/oder Querbewegungen (9,10) aufweist.

8. Vorrichtung nach Anspruch 1 bis 4, dadurch gekennzeichnet, daß zur Längsbewegung der Kassette eine Zahnstange (4) vorgesehen ist zum Zusammenwirken mit am Handler vorgesehenen Transporteinrichtungen, wie Zahnrad. Zahnriemen o.dgl.

9. Vorrichtung nach einem der Ansprüche 1 bis 8, dadurch gekennzeichnet, daß zur Steuerung der Lage der Kassette am Handler an dieser eine Positioniervorrichtung, vorzugsweise die Blende einer Lichtschranke (7), vorgesehen ist.

10. Vorrichtung nach einem der Ansprüche 1 bis 9, dadurch gekennzeichnet, daß in den Einstecköffnungen den lichten Querschnitt verkleinernde Federelemente (8) zum kraftschlüssigen Fixieren der Verpackungseinheiten (5) vorgesehen sind.

11. Vorrichtung nach Anspruch 10, dadurch gekennzeichnet, daß als Federelement mindestens ein in einer parallel zur Längsabmessung der Kassette über alle Einstecköffnungen verlaufende Nut verlegter Gummirundkörper (8) vorgesehen ist.

12. Vorrichtung nach Anspruch 11, dadurch gekennzeichnet, daß die Gummirundkörper (8) mit einer Blattfeder abgedeckt sind.

13. Vorrichtung nach einem der Ansprüche 1 bis 12, dadurch gekennzeichnet, daß den im Bodenbereich der Kassette vorgesehenen Durchlaßöffnungen für die Bauteile (2) eine lösbare Verriegelung (3) zugeordnet ist.

14. Vorrichtung nach einem der Ansprüche 1 bis 9, dadurch gekennzeichnet, daß auf der Kassette ein Schreib- und/oder Lesespeicher angebracht ist.

FIG.1

FIG.2

# FIG.3